# EUROPEAN PATENT APPLICATION

(11) **EP 4 687 201 A1**
(43) Date of publication of application: **04.02.2026**
(21) Application number: 25166516.2
(22) Date of filing: 27.03.2025
(51) Int. Cl.: H01M 50/204

(54) **COMBINER CABINET AND ENERGY STORAGE SYSTEM**

(30) Priority: 31.07.2024 CN 202421848659 U; 25.10.2024 WO PCT/CN2024/127461
(71) Applicant: Eve Energy Storage Co., Ltd, Wuhan, Hubei 430074 (CN)
(72) Inventor: CHEN, Hao, Wuhan, Hubei, 430074 (CN); ZHANG, Han, Wuhan, Hubei, 430074 (CN); FENG, Chaojun, Wuhan, Hubei, 430074 (CN); GUI, Ke, Wuhan, Hubei, 430074 (CN)
(74) Representative: Berggren Oy

(57) **Abstract**

A combiner cabinet and an energy storage system are provided. The combiner cabinet includes a cabinet body, a cabinet door, at least one electrical element assembly, a mounting chamber is formed in the cabinet body, the cabinet door is connected to the cabinet body, the cabinet body includes a first side wall arranged opposite to the cabinet door, and the cabinet door and the first side wall are arranged along a first direction; the electrical element assembly is, arranged in the mounting chamber, the electrical element assembly includes a positive electrode portion and a negative electrode portion arranged at intervals, the positive electrode portion and the negative electrode portion are arranged in the first direction.

## Description

### TECHNICAL FIELD

The present application relates to the field of energy storage technology, and in particular to a combiner cabinet and an energy storage system.

### BACKGROUND

In related technologies, a combiner cabinet is often served as a bridge to connect a battery pack to the outside, and the battery pack is charged or discharged through the combiner cabinet.

### SUMMARY

In related technologies, a combiner cabinet generally includes a large number of electrical elements, and the large number of electrical elements are often arranged in one layer along a length direction of the combiner cabinet. Distances between the electrical elements at two ends are long, thus the required wiring distances between the electrical elements are long, which makes it inconvenient for workers to operate.

The present invention provides a combiner cabinet, and the combiner cabinet includes:

a cabinet body, a cabinet door, and at least one electrical element assembly, a mounting chamber is formed in the cabinet body, the cabinet door is connected to the cabinet body to cover or expose the mounting chamber, the cabinet body includes a first side wall arranged opposite to the cabinet door, and an arrangement direction of the cabinet door and the first side wall is a first direction; the at least one electrical element assembly is arranged in the mounting chamber; and the at least one electrical element assembly includes a positive electrode portion and a negative electrode portion arranged at intervals, the positive electrode portion is configured to be electrically connected to a positive electrode output terminal of an external high-voltage box and electrically connected to a positive electrode of a battery pack, the negative electrode portion is configured to be electrically connected to a negative electrode output terminal of the external high-voltage box and electrically connected to a negative electrode of the battery pack, the positive electrode portion and the negative electrode portion are arranged in the first direction.

The present invention further provides an energy storage system, and the energy storage system includes any of the combiner cabinet as described above.

In the combiner cabinet provided in the present invention, a cabinet door and a first side wall are arranged in a first direction, at least one electrical element assembly is arranged in a mounting chamber, and a positive electrode portion and a negative electrode portion of the at least one electrical element assembly are arranged in the first direction, so that distances between electrical elements at two ends are short, thus the required wiring distances between the electrical elements are short, which makes it convenient for workers to operate.

The energy storage system provided in the present invention includes the combiner cabinet as described above, distances between electrical elements at two ends are short, thus the required wiring distances between the electrical elements are short, which makes it convenient for workers to operate.

### BRIEF DESCRIPTION OF THE DRAWINGS

FIG. 1 is an exploded view of a combiner cabinet provided in the present invention;
FIG. 2 is a schematic diagram of a structure of a shelf in FIG. 1;
FIG. 3 is schematic diagram of a circuit of a combiner cabinet provided in the present invention;
FIG. 4 is a perspective view of a combiner cabinet provided in the present invention from a first perspective with a cabinet door removed;
FIG. 5 is a perspective view of a combiner cabinet provided in the present invention from a second perspective with a cabinet door removed;
FIG. 6 is a schematic diagram of a structure of a cabinet door in FIG. 1;
FIG. 7 is a perspective view of a combiner cabinet provided in the present invention from a third perspective with a cabinet door removed;
FIG. 8 is a perspective view of a combiner cabinet provided in the present invention from a fourth perspective with a cabinet door removed; and
FIG. 9 is a perspective view of a combiner cabinet provided in the present invention from a fifth perspective with a cabinet door removed.

Reference numerals in the accompany drawings:
10: cabinet body; 11: cabinet door; 12: mounting chamber; 121: first mounting chamber; 123: second mounting chamber; 1211: first mounting space; 1213: second mounting space; 13: first side wall; 14: electrical element assembly; 15: second side wall; 17: third side wall; 18: top wall; 19: bottom wall; 1010: air outlet; 1030: air inlet; 20: shelf; 21: first shelf; 23: second shelf; 25: third shelf; 31: Battery Management System (BMS) control part; 33: signal relay; 35: air switch; 36: wiring groove; 37: wiring terminal; 38: AC/DC power supply; 40: first operation module; 41: indicator light module; 411: operation indicator light; 413: fault indicator light; 415: closing indicator light; 412: over-high temperature indicator light; 414: 24 V voltage indicator light; 416: low State of Charge (SOC) indicator light; 43: switch module; 431: remote/local control switch; 433: start/stop control switch; 435: silencer control switch; 437: emergency stop switch; 45: buzzer; 47: display module; 50: second operation module; 60: warning module; 601: first filter screen; 602: second filter screen; 603: insulating plate; 70: positive electrode portion; 71: positive fuse; 72: positive high-voltage relay; 73: positive electrode interface; 74: circuit breaker; 741: first circuit breaker; 743: second circuit breaker; 701: first copper busbar; 75: cluster high-voltage positive electrode wiring copper busbar; 76: cluster high-voltage positive electrode-to-circuit breaker copper busbar; 77: circuit breaker-to-output positive copper busbar; 80: negative electrode portion; 801: second copper busbar; 81: negative fuse; 82: negative high-voltage relay; 83: negative electrode interface; 85: cluster high-voltage negative wiring copper busbar; 86: cluster high-voltage negative electrode-to-circuit breaker copper busbar; 87: circuit breaker-to-output negative copper busbar; 90: wire entrance; 91: pre-charging resistance; 100: control portion; 101: first sub-control portion; 103: second sub-control portion; 200: adjusting and indicating portion; 300: auxiliary power portion; 301: auxiliary power positive fuse; 303: auxiliary power negative fuse; 305: auxiliary power positive electrode interface; 307: auxiliary power negative electrode interface; 400: electrical surge protection portion;
401: first electrical surge fuse; 405: electrical surge protector; 403: second electrical surge fuse.

### DETAILED DESCRIPTION

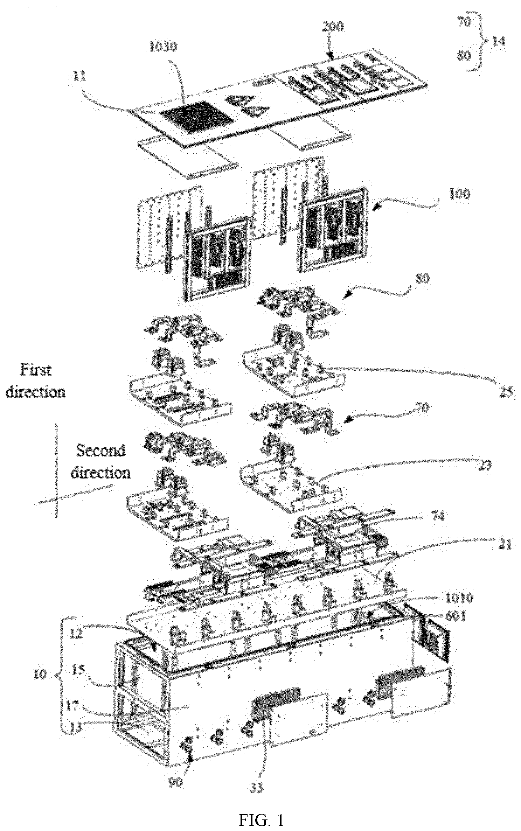

Please refer to FIG. 1, in an embodiment of the present invention, a combiner cabinet includes a cabinet body 10 and a cabinet door 11. A mounting chamber 12 is formed in the cabinet body 10. The cabinet door 11 is connected to the cabinet body 10 and configured to expose or cover the mounting chamber 12, or configured to open or close the cabinet body 10. A shelf 20 is mounted in the mounting chamber 12. The cabinet door 11 is rotatably connected to the cabinet body 10.

The cabinet body 10 includes a first side wall 13, a second side wall 15, and a third side wall 17. The first side wall 13, the second side wall 15, and the third side wall 17 define the mounting chamber 12, in which the second side wall 15 and the third side wall 17 are arranged opposite to each other. The first side wall 13 is arranged opposite to the cabinet door 11. The first side wall 13 is located between the second side wall 15 and the third side wall 17. Two opposite sides of the first side wall 13 are connected to the second side wall 15 and the third side wall 17 respectively.

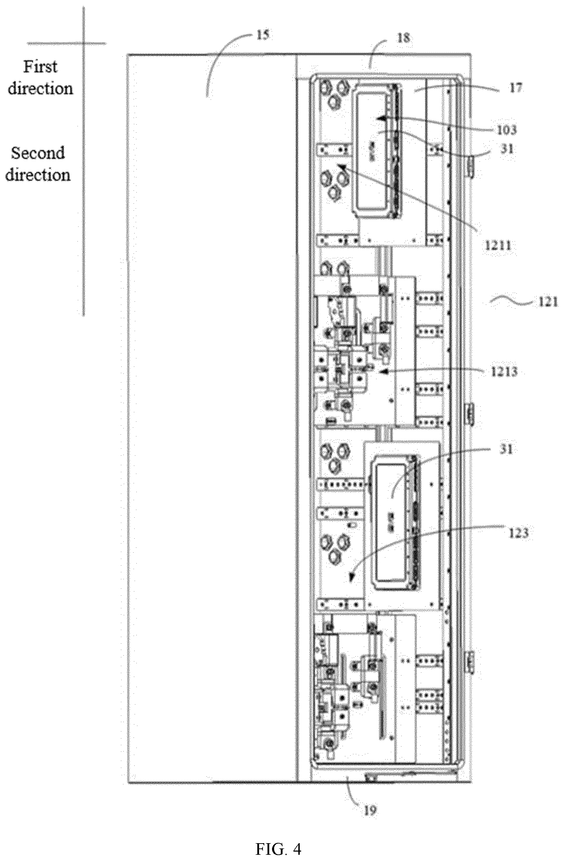

Please refer to FIG. 4, the cabinet body further includes a top wall 18 and a bottom wall 19. It is easy to understand that the top wall 18 is located at a top of the cabinet body 10, and the bottom wall 19 is located at a bottom of the cabinet body. In a height direction of the combiner cabinet, the top wall 18, the first side wall 13 and the bottom wall 19 are arranged in sequence. The cabinet door 11 and the first side wall 13 are arranged in a first direction (or a width direction of the cabinet body), the top wall 18 and the bottom wall 19 are arranged in a second direction (or a height direction of the cabinet body), and the first direction is perpendicular to the second direction.

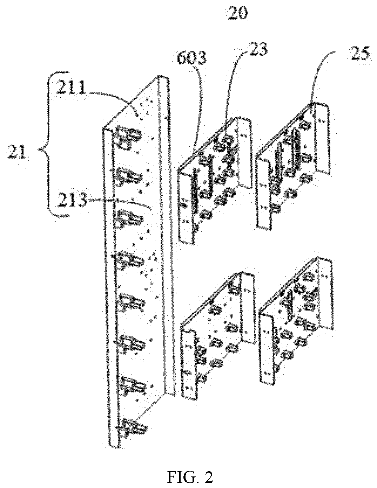

Please refer to FIG. 2, the combiner cabinet further includes at least one shelf 20, and the shelf 20 is mounted in the mounting chamber 12 of the cabinet body, and is configured to mount an electrical element assembly 14. The shelf 20 is arranged between the cabinet door 11 and the first side wall 13, and the shelf 20 is arranged opposite to the cabinet door 11. The first side wall 13, the shelf, and the cabinet door 11 are arranged in the first direction or the width direction of the combiner cabinet. Two opposite sides of the shelf 20 are connected to the second side wall 15 and the third side wall 17 respectively.

Since the electrical element assembly 14 includes a lot of electrical elements, in case that they are all mounted on the same plane, the cabinet body will become very large. In order to further reduce a volume of the combiner cabinet, there are multiple shelves 20, and the multiple shelves 20 are arranged in the first direction or the width direction of the combiner cabinet. In some embodiments, the shelves 20 include a first shelf 21 and a second shelf 23 arranged in sequence in the first direction (or the width direction of the combiner cabinet). Both the first shelf 21 and the second shelf 23 are configured to mount the electrical element assembly 14, and the second shelf 23 is located between the first shelf 21 and the cabinet door 11. In the width direction of the combiner cabinet, a projection of the first shelf 21 on the cabinet door is at least partially located above a projection of the second shelf 23 on the cabinet door 11. In the embodiments of the present invention, the cabinet door and the first side wall are arranged in the first direction. The electrical element assembly 14 is arranged in the mounting chamber, and a positive electrode portion and a negative electrode portion of the electrical element assembly 14 are arranged in the first direction, so that distances between electrical elements at two ends are short, thus wiring distances between the electrical elements are short, which makes it convenient for works to operate.

The shelves 20 further include a third shelf 25, the third shelf 25 is configured to mount the electrical element assembly 14. The first shelf 21 is closer to the first side wall 13 than the second shelf 23 and the third shelf 25, the third shelf 25 is closer to the cabinet door than the first shelf 21 and the second shelf 23, and the second shelf 23 is located between the first shelf 21 and the third shelf 25. In the width direction of the combiner cabinet, a projection of the first shelf 21 on the cabinet door 11 is at least partially located above a projection of the third shelf 25 on the cabinet door 11. In some embodiments, the first shelf 21 is mounted on the first side wall 13. In some other embodiments, two opposite sides of the first shelf 21 are connected to the second side wall 15 and the third side wall 17 respectively.

The combiner cabinet further includes at least one electrical element assembly electrical element assembly 14, and the electrical element assembly 14 is mounted in the mounting chamber 12 of the cabinet body 10. The electrical element assembly 14 includes a positive electrode portion 70 and a negative electrode portion 80. The positive electrode portion 70 and the negative electrode portion 80 are arranged at intervals. The positive electrode portion 70 is configured to be electrically connected to a positive electrode output terminal of an external high-voltage box and electrically connected to a positive electrode of a battery pack. The negative electrode portion 80 is configured to be electrically connected to a negative electrode output terminal of the external high-voltage box and electrically connected to a negative electrode of the battery pack.

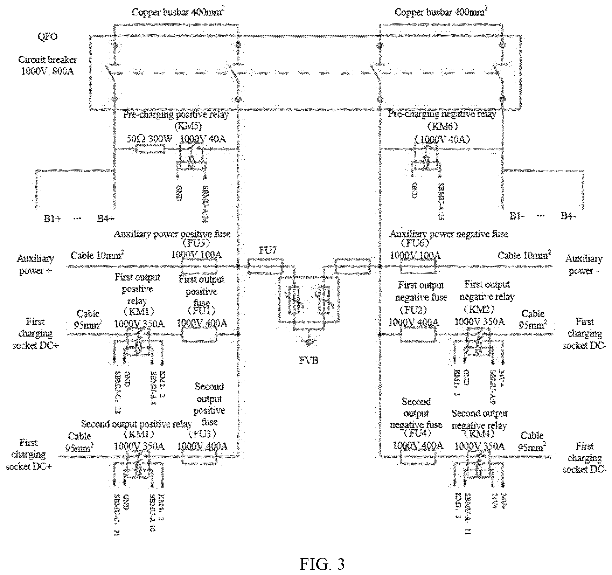

Please refer to FIG. 3, in some embodiments, the external high-voltage box is configured as an external multi-cluster high-voltage box, and the combiner cabinet combines current of the external multi-cluster high-voltage box, and further control current and/or voltage input into a battery pack. Positive electrode output terminals (referring to B1 +... B4 + in FIG. 3) of the external multi-cluster high-voltage box are connected to the combiner cabinet through a wire harness, so that the positive electrode output terminals, a first circuit breaker 741, a positive fuse, a positive high-voltage relay, and a positive electrode interface of the external multi-cluster high-voltage box are connected to each other in sequence, and the positive electrode interface is configured to be electrically connected to the positive electrode of a battery pack. Negative electrode output terminals (referring to B1-... B4- in FIG. 3) of the external multi-cluster high-voltage box are connected to the combiner cabinet through a wire harness, so that the negative electrode output terminals, a second circuit breaker 743, a negative fuse, a negative high-voltage relay, and a negative electrode interface of the external multi-cluster high-voltage box are electrically connected to each other in sequence, and the negative electrode interface is configured to be electrically connected to the negative electrode of the battery pack mentioned above. Therefore, the external multi-cluster high-voltage box is electrically connected to the battery pack through the electrical element assembly 14 to realize functions of charging and discharging the battery pack. In some embodiments, a maximum current of a single cluster high-voltage box is less than or equal to 112 A.

For example, the external high-voltage box is configured as a four-cluster high-voltage box, current of the four cluster high-voltage box is combined through the combiner cabinet according to the embodiments of the present invention, and charge a battery pack. The combiner cabinet according to the embodiments of the present invention is served as a bridge to connect the battery pack to the outside, and the battery pack is charged or discharged through the combiner cabinet.

In some embodiments, the positive electrode portion 70 and the negative electrode portion 80 are arranged in the first direction (or the width direction of the combiner cabinet). In these embodiments, the positive electrode portion 70 and the negative electrode portion 80 are arranged in the first direction respectively, which makes the layout reasonable, the structure compact, and an occupied space of the combiner cabinet small.

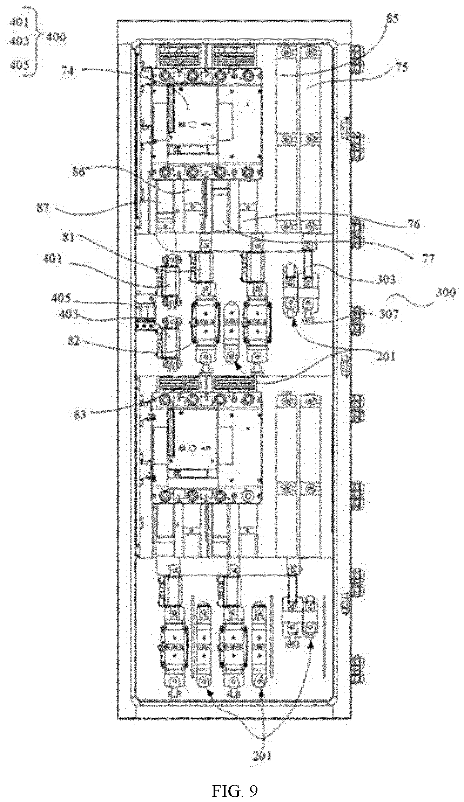

Please refer to FIG. 9, the positive electrode portion 70 includes a positive fuse 71, a positive high-voltage relay 72, and a positive electrode interface 73. The positive fuse 71, the positive high-voltage relay 72, and the positive electrode interface 73 are electrically connected to each other in sequence. The positive fuse 71 is configured to be electrically connected to a positive electrode output terminal of the external high-voltage box, and the positive electrode interface 73 is configured to be electrically connected to a positive electrode of a battery pack. In the embodiments of the present invention, the positive electrode portion 70 includes a positive fuse 71. In case that the current exceeds a specified value, the positive fuse is fused in time to protect the safety of a circuit of the positive electrode portion 70.

The electrical element assembly 14 further includes a circuit breaker 74. The circuit breaker 74 includes a first circuit breaker 741, and the first circuit breaker 741 is mounted in the mounting chamber 12. In the embodiments of the present invention, the first circuit breaker 741 is arranged to be connected to the positive electrode portion 70, so that when safety issues occur, the first circuit breaker 741 is disconnected in time to protect the safety of the circuit. In addition, the first circuit breaker 741 and the positive electrode portion 70 are arranged in the first direction, and the first circuit breaker 741 is closer to the first side wall 13 than the positive electrode portion 70 and the negative electrode portion 80, which makes the structure compact and the layout reasonable.

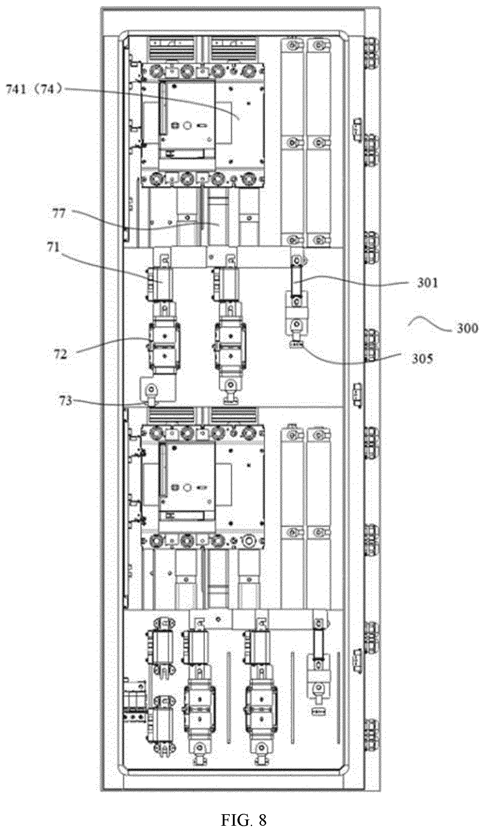

Please refer to FIG. 8, the negative electrode portion 80 includes a negative fuse 81, a negative high-voltage relay 82, and a negative electrode interface 83. The negative fuse 81, the negative high-voltage relay 82, and the negative electrode interface 83 are electrically connected to each other in sequence. The negative fuse 81 is configured to connect to a negative electrode output terminal of the external high-voltage box, and the negative electrode interface 83 is configured to connect to a negative electrode of a battery pack. In the embodiments of the present invention, the negative electrode portion 80 includes a negative fuse. In case that the current exceeds a specified value, the negative fuse is fused in time to protect the safety of a circuit of the negative electrode portion 80. Since separate fuses are arranged in the positive electrode portion 70 and the negative electrode portion 80 to protect the positive electrode portion 70 and the negative electrode portion 80, the safety of the circuit is improved.

The circuit breaker 74 further includes a second circuit breaker 743. The second circuit breaker 743 is mounted in the mounting chamber 12. The second circuit breaker 743 is electrically connected to the negative electrode portion 80, and the second circuit breaker and the negative electrode portion 80 are arranged in the first direction. In the embodiments of the present invention, the second circuit breaker 743 is arranged to be electrically connected to the negative electrode portion 80, in case that safety issues occur, the second circuit breaker 743 is disconnected in time to protect the safety of the circuit. In addition, the second circuit breaker 743 is closer to the first side wall 13 than the positive electrode portion 70 and negative electrode portion 80.

Specifically, the first circuit breaker 741, the positive fuse 71, the positive high-voltage relay 72, and the positive electrode interface 73 are electrically connected to each other in sequence. The positive electrode interface is configured to be electrically connected to a positive electrode of the battery pack, and the first circuit breaker 741 is configured to be electrically connected to the positive electrode output terminal of the external high-voltage box. The second circuit breaker 743, the negative fuse 81, the negative high-voltage relay 82, and the negative electrode interface 83 are connected to each other in sequence. The negative electrode interface is configured to be electrically connected to a negative electrode of the battery pack. The second circuit breaker 743 is configured to be electrically connected to the negative electrode output terminal of the external high-voltage box. In the embodiments of the present invention, the first circuit breaker 741 and the second circuit breaker 743 are configured to realize the disconnection or connection of the entire high-voltage circuit. Specifically, the first circuit breaker 741 is configured to realize the disconnection or connection of the positive electrode portion, and the second circuit breaker 743 is configured to realize the disconnection or connection of the negative electrode portion. Through cooperation of the first circuit breaker 741 and the second circuit breaker 743, the entire high-voltage circuit is disconnected or connected.

In case that only the first circuit breaker 741 is arranged in the positive electrode portion 70, even if the first circuit breaker 741 is disconnected, in some unexpected situations, such as reverse connection or lightning strike, resulting in a high voltage at the negative electrode of the battery pack, the battery pack is damaged through a pathway on the negative electrode side, which would also cause safety hazards. In case that only the second circuit breaker 743 is arranged in the negative electrode portion 80, even if the second circuit breaker 743 is disconnected, the positive electrode portion 70 is in a state of high voltage, which causes safety hazards. In the embodiments of the present invention, in the positive electrode portion 70, the positive electrode output terminal of the high-voltage box is connected to the first circuit breaker 741, and in the negative electrode portion 80, the negative electrode output terminal of the high-voltage box is connected to the second circuit breaker 743, which further protects the circuit.

In the embodiments of the present invention, fuses are arranged in both the positive electrode portion 70 and the negative electrode portion 80, and circuit breakers are connected to both the positive electrode portion 70 and the negative electrode portion 80, so that both the positive electrode portion 70 and the negative electrode portion 80 are protected, and the safety of the circuit is high. The first electrical element assembly 14 further includes a first copper busbar 701 and a second copper busbar 801. The positive electrode portion 70 is electrically connected to the positive electrode output terminal of the external high-voltage box through the first copper busbar 701, and the negative electrode portion 80 is electrically connected to the negative electrode output terminal of the external high-voltage box through the second copper busbar 801, which reduces heat production.

The first copper busbar 701 is mounted on the first shelf 21, the second copper busbar 801 is mounted on the first shelf 21, and the second copper busbar 801 and the first copper busbar 701 are arranged at intervals, which makes it convenient to connect the first copper busbar 701 to the positive electrode portion 70 and the positive electrode output terminal of the external high-voltage box, and connect the second copper busbar 801 to the negative electrode portion 80 and the negative electrode output terminals of the external high-voltage box respectively, so that the structure is compact.

In some embodiments, the first copper 701 include a cluster high-voltage positive electrode wiring copper busbar 75, and a cluster high-voltage positive electrode-to-circuit breaker copper busbar 76. The second copper 801 includes a cluster high-voltage negative wiring copper busbar 85, and a cluster high-voltage negative electrode-to-circuit breaker copper busbar 86. The positive electrode output terminal of the high-voltage box is connected to the cluster high-voltage positive electrode wiring copper busbar 75 through a wire harness, and connected to the first circuit breaker 741 through the cluster high-voltage positive electrode to the circuit breaker copper busbar 76. The first circuit breaker 741 is electrically connected to the positive fuse 71 through a circuit breaker-to-output positive copper busbar 77. The positive fuse 71 is connected to the positive high-voltage relay 72 through a copper busbar. The positive high-voltage relay 72 is connected to a positive output wire harness through an output wire harness copper busbar. The positive output wire harness is connected to the positive electrode interface 73. The circuit breaker-to-output positive copper busbar 77 is mounted on a side, facing the cabinet door 11, of the second shelf 23.

The negative electrode output terminal of the high-voltage box is connected to the cluster high-voltage negative wiring copper busbar 85 through a wire harness, and connected to the second circuit breaker 743 through the cluster high-voltage negative electrode-to-circuit breaker copper busbar 86. A circuit breaker-to-output negative copper busbar 87 is electrically connected to the negative fuse 81. The negative fuse 81 is connected to the negative high-voltage relay 82 through the copper busbar. The negative high-voltage relay 82 is connected to a negative output wire harness through the copper busbar. The negative output wire harness is connected to the negative electrode interface 83. The circuit breaker-to-output negative copper busbar 87 is mounted on a side, facing the cabinet door 11, of the third shelf 25.

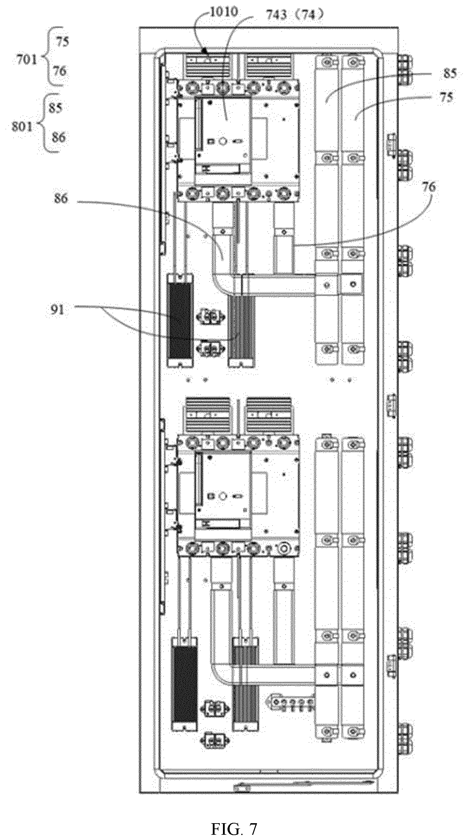

Please refer to FIG. 7, in order to protect fuses and relays, prevent excessive charging current at the moment of direct power on, and avoid damage to the fuses and switch components such as the relays caused by excessive instantaneous current, a pre-charging resistance 91 is further arranged, and the pre-charging resistance 91 is mounted on a side, facing the second shelf 23, of the first shelf 21.

In some embodiments, the circuit breaker 74 (including the first circuit breaker 741 and the second circuit breaker 743) is mounted on a side, close to the cabinet door 11, of the first shelf 21, the positive electrode portion 70 is mounted on a side, close to the cabinet door 11, of the second shelf 23, and the negative electrode portion 80 is mounted on a side, close to the cabinet door 11, of the third shelf 25. In these embodiments, multiple shelves 20 are arranged, and the circuit breaker 74, the positive electrode portion 70, and the negative electrode portion 80 are mounted on different shelves, so that the circuit breaker 74, the positive electrode portion 70, and the negative electrode portion 80 are arranged in the first direction.

In some embodiments, in addition to the positive electrode portion 70 and the negative electrode portion 80, the electrical element assembly 14 further includes a control portion 100. The control portion 100 is mounted in the mounting chamber 12. The control portion 100 is configured to be electrically connected to the positive electrode portion 70, the negative electrode portion, 80 and the battery pack. The control portion 100 is further configured to be electrically connected to a communication signal terminal of the external high-voltage box to detect states of the external high-voltage box and the battery pack.

In the related art, an energy storage system usually includes a combiner cabinet in a form of an independent equipment cabinet, and current of the external high-voltage box is combined through the combiner cabinet. The function of the combiner cabinet is simple. In order to control input or output current and voltage, another electric control cabinet in a form of an independent equipment cabinet is needed, which occupies a large space. In the embodiments of the present invention, the electrical element assembly 14 mounted in the cabinet body includes the positive electrode portion, the negative electrode portion, and the control portion. The external high-voltage box is connected to the positive electrode and the negative electrode of the battery pack through the positive electrode portion and the negative electrode portion. Current is combined through the positive electrode portion and the negative electrode portion, and the communication signal terminal of the external high-voltage box is electrically connected through the control portion, so that the states of the external high-voltage box and the battery pack is detected, which makes the functions of the combiner cabinet diverse. In addition, compared with the solution in the related art in which the control portion is arranged in a separate cabinet body, and the positive electrode portion and the negative electrode portion are arranged in another separate cabinet body, in the embodiments of the present invention, the control portion, the positive electrode portion, and the negative electrode portion are arranged in the same cabinet body, and the control portion and the positive electrode portion are arranged in a length direction or a width direction of the combiner cabinet, so that one cabinet body is eliminated, and the structure among the control portion, the positive electrode portion, and the negative electrode portion is compact.

In the embodiments of the present invention, the control portion 100 is arranged in the cabinet body, and the control portion 100 is configured to be electrically connected to the communication signal terminal of the external high-voltage box, which has the following functions. In a first aspect, the communication signal terminal of the external high-voltage box supplies power to the control portion. In a second aspect, the communication signal terminal of the external high-voltage box detects the states of the external high-voltage box and the battery pack in real time. If there is a fault in the high-voltage box, it is fed back to the combiner cabinet through the communication signal terminal, and fed back to the driver's console through the combiner cabinet. In a third aspect, the state of the battery pack is detected and fed back in real time through the communication signal terminal, and the state includes a working voltage, a working current, a remaining capacity, a remaining battery life of the battery system and so on. Compared with the solution in the related art in which the energy storage system usually includes an electric control cabinet and a combiner cabinet both in a form of an independent equipment cabinet, the combiner cabinet provided in the embodiments of the present invention is more diverse in function, more compact in structure and smaller in occupied space.

It should be noted that the cluster high-voltage box outside the combiner cabinet includes a positive electrode output terminal, a negative electrode output terminal, and a communication signal terminal. A wire entrance 90 is formed in a side wall of the cabinet body, and is configured for inserting an external wire harness. The wire entrance 90 includes a positive electrode wire entrance, a negative electrode wire entrance, and a communication wire entrance. A high-voltage wire harness connected to the high-voltage box is mounted at the wire entrance 90 through a gland. The wire harness passing through is locked by the gland to improve protection of the cabinet body. Foreign objects and moisture resulting in fault of the combiner cabinet and short circuits are avoided from entering the combiner cabinet.

The communication signal terminal enters the cabinet body through the communication wire entrance formed in the side wall of the cabinet body, and is connected to a Battery Management System (BMS) control part 31. The positive electrode output terminal of the external high-voltage box enters the cabinet body through the positive electrode wire entrance formed in the side wall of the cabinet body, and is connected to the first copper busbar 701, and inserted into the first circuit breaker 741. The negative electrode output terminal enters the cabinet body through the negative electrode wire entrance formed in the side wall of the cabinet body, and is connected to the second copper busbar 801, and inserted into the second circuit breaker 743.

In some embodiments, the control portion 100 and the positive electrode portion 70 are arranged in the length direction of the combiner cabinet, and the positive electrode portion 70 and the negative electrode portion 80 are arranged in the width direction, that is, the first direction, of the combiner cabinet, so as to make the structure compact and occupied space small.

In some embodiments, the control portion 100 includes a first sub-control portion 101 and a second sub-control portion 103. The first sub-control portion 101, the positive electrode portion 70, and the second sub-control portion 103 are arranged in sequence in the length direction of the combiner cabinet. In these embodiments, there are two control portions 100, and the first sub-control portion 101 and the second sub-control portion 103 are located on both sides of the positive electrode portion 70 and the negative electrode portion 80. The first sub-control portion 101 is mounted on the second side wall 15, and the second sub-control portion 103 is mounted on the third side wall 17.

In some embodiments, the second sub-control portion 103 of the control unit 100 includes a BMS control part 31. The BMS control part 31 is configured to be electrically connected to the communication signal terminal of the external high-voltage box. The BMS control part 31 is electrically connected to the positive electrode portion 70 and the negative electrode portion 80, respectively.

In some embodiments, the electrical element assembly 14 further includes an adjusting and indicating portion 200. The adjusting and indicating portion is mounted on a side, away from the mounting chamber 12, of the cabinet door 11. The adjusting and indicating portion 200 are electrically connected to the BMS control part 31, and is configured to adjust and indicate working conditions of the battery pack.

In the embodiments of the present invention, there are multiple electrical element assemblies 14. The specific structure of the electrical element assembly 14 has been explained above. Each electrical element assembly 14 includes the positive electrode portion 70, the negative electrode portion 80, the control portion as described above, and the specific content will not be repeated here.

Each electrical element assembly 14 is configured to be electrically connected to an external multi-cluster high-voltage box, and configured to be electrically connected to one battery pack. Multiple electrical element assemblies 14 are arranged from top to bottom in the height direction of the combiner cabinet. As such, current of multiple battery packs is combined simultaneously through one combiner cabinet according to the embodiments of the present invention, which makes it small in occupied area, convenient to use, and low in cost.

In the embodiments of the present invention, each electrical element assembly 14 is configured to be electrically connected to an external multi-cluster high-voltage box, and is configured to be electrically connected to one battery pack, thereby current of the external multi-cluster high-voltage box is combined through one electrical element assembly 14. Once the current of the external multi-cluster high-voltage box is combined through the electrical element assembly 14, the battery pack is charged and discharged. In one cabinet body, multiple electrical element assemblies 14 are arranged and configured to be electrically connected to multiple battery packs, so as to meet combination requirements for current of multiple battery packs, thereby the situation in related art where the combiner cabinet is difficult to meet the combination requirements for current of multiple battery packs is improved.

In some embodiments, in a sake of description, the multiple battery packs include at least a first battery pack and a second battery pack, and the multiple electrical element assemblies 14 include at least a first electrical element assembly 14 and a second electrical element assembly 14. The mounting chamber of the cabinet body includes a first mounting chamber 121 and a second mounting chamber 123 arranged from top to bottom in the height direction of the combiner cabinet.

The first electrical element assembly 14 is mounted in the first mounting chamber 121. The first electrical element assembly 14 is electrically connected to the external high-voltage box, the first electrical element assembly 14 is electrically connected to the first battery pack, and the external high-voltage box is an external multi-cluster high-voltage box. The second electrical element assembly 14 is mounted in the second mounting chamber 123, the second electrical element assembly 14 is electrically connected to the external high-voltage box, the second electrical element assembly 14 is electrically connected to the second battery pack, and the external high-voltage box is an external multi-cluster high-voltage box.

In some embodiments, a single battery pack is connected to a four cluster high-voltage box, with an eight cluster high-voltage box outside. The first electrical element assembly 14 combines current of the four cluster high-voltage box, and is configured for charging the first battery pack. The second electrical element assembly 14 combines current of another four cluster external high-voltage box, and is configured for charging the second battery pack. In the embodiments of the present invention, the current combination of high voltage and the control of low voltage of two or more battery packs are realized at the same time through one combiner cabinet, which makes it small in occupied area, convenient to use, and low in cost.

Please refer to FIG. 4, the first mounting chamber 121 includes a first mounting space 1211 and a second mounting space 1213 arranged in the height direction of the combiner cabinet. Specifically, in the first mounting chamber 121, in the width direction of the combiner cabinet, a projection of the first shelf 21 on the cabinet door (or the first side wall) is at least partially located above a projection of the second shelf 23 on the cabinet door 11 (or the first side wall). In the width direction of the combiner cabinet, a projection of the first shelf 21 on the cabinet door is at least partially located above a projection of the third shelf 25 on the cabinet door 11. As such, at least a part of the first shelf 21 is directly opposite to the cabinet door 11, and the first mounting space 1211 is formed.

A part of the first shelf 21, the second shelf 23 and the third shelf 25 form the second mounting space 1213. The second mounting space 1213 includes a first sub-mounting chamber, a second sub-mounting chamber, and a third sub-mounting chamber. A part of the first shelf and the second shelf 23 define the first sub-mounting chamber, the second shelf 23 and the third shelf 25 define the second sub-mounting chamber, and the third shelf 25 and the cabinet door define the third sub-mounting chamber. At least a part of the first circuit breaker 741 is mounted in the first mounting space 1211, and at least a part of the second circuit breaker 743 is mounted in the first mounting space 1211.

One embodiment is as follows. Two opposite sides of the first shelf 21 are connected to the second side wall and the third side wall respectively, through, for example, welding or screwing. Two opposite sides of the second shelf 23 are connected to the second side wall and the third side wall respectively, through, for example, welding or screwing. Two opposite sides of the third shelf 25 are connected to the second side wall and the third side wall respectively, through, for example, welding or screwing. As such, the first shelf 21, the second shelf 23, and the third shelf 25 are mounted in the cabinet body, which makes the structure compact, reduces a volume and an occupied space of the cabinet body.

For the positional relationships among the first shelf 21, the second shelf 23, and the third shelf 25 in the second mounting chamber 123, reference is made to their positional relationships in the first mounting chamber 121.

In some embodiments, each electrical element assembly 14 includes the positive electrode portion 70 and the negative electrode portion 80 as described above. The positive electrode portion 70 is configured to be electrically connected to the positive electrode output terminal of the external high-voltage box and electrically connected to the positive electrode of the battery pack. The negative electrode portion 80 is configured to be electrically connected to the negative electrode output terminal of the external high-voltage box and electrically connected to the negative electrode of the battery pack. As such, one electrical element assembly 14 corresponds to one battery pack, multiple electrical element assemblies 14 correspond to multiple battery packs, with a one-to-one correspondence between the electrical element assembly(s) 14 and the battery pack(s).

Please refer to FIG. 3, due to the connection of a multi-cluster high-voltage box, the current flow capacity of one positive electrode interface cooperating with one negative electrode interface would not satisfy the usage requirements. Therefore, multiple positive electrode portions 70 and multiple negative electrode portions 80 are arranged, in which each positive electrode portion 70 corresponds to one negative electrode portion 80. That is, each electrical element assembly 14 includes multiple positive electrode portions 70 and multiple negative electrode portions 80. Therefore, each electrical element assembly 14 includes multiple positive electrode interfaces (reference is made to a charging socket 1DC + in FIG. 3 and a charging socket 2DC + in FIG. 3), and multiple negative electrode interfaces (reference is made to a charging socket 1DC-in FIG. 3 and a charging socket 2DC- in FIG. 3), with a one-to-one correspondence between the positive electrode interface(s) and the negative electrode interface(s), and one positive electrode interface cooperates with one negative electrode interface to form a charging and discharging interface. Multiple positive electrode portions 70 are each electrically connected to the positive electrode of one battery pack, and multiple negative electrode portions 80 are each electrically connected to the negative electrode of one battery pack. Multiple positive electrode portions 70 and multiple negative electrode portions 80 are arranged to provide a larger current for one battery pack.

In some embodiments, since a maximum input current of a four cluster high-voltage box is about 448 A, and the current flow capacity of a single charging and discharging interface is about 250 A, in order to satisfy the current flow requirements, two positive electrodes 70 and two negative electrodes 80 are arranged and are configured to share current.

In some embodiments, for the control portion 100, for the convenience of users to distinguish between two battery packs, each electrical element assembly 14 includes a control portion. The control portion is configured to be electrically connected to the electrical element assembly 14 and configured to be electrically connected to the battery pack. The control portion is further configured to be electrically connected to the communication signal terminal of the external high-voltage box to detect the states of the external high-voltage box and the battery pack. As such, one control portion controls one battery pack, an accurate control is realized.

In some embodiments, the control portion includes a first control portion and a second control portion. The first control portion is mounted in the first mounting chamber 121, and the second control portion is mounted in the second mounting chamber 123. The first control portion is electrically connected to the first battery pack and the first electrical element assembly 14 to detect the states of the external high-voltage box and the first battery pack. The second control portion is electrically connected to the second battery pack and the second electrical element assembly 14 to detect the states of the external high-voltage box and the second battery pack.

The first battery pack and the second battery pack are respectively controlled by the first control portion and the second control portion, so that the control portions of the two battery packs are independent of each other, and do not interfere with each other, which reduces a failure rate and improve a control accuracy.

In some embodiments, in each electrical element assembly 14, the control portion includes two parts, a first sub-control portion 101 and a second sub-control portion 103 electrically connected to each other. In the length direction of the cabinet body, the first sub-control portion and the second sub-control portion are located on two sides of the cabinet body, and are mounted on the second side wall and the third side wall respectively.

Specifically, the second sub-control portion is mounted on a side, facing the second side wall of the cabinet body, of the third side wall of the cabinet body. The first sub-control portion is mounted on a side, located on a left side of the cabinet body and facing the third side wall of the cabinet body, of the second side wall of the cabinet body.

In some embodiments, in the width direction of the combiner cabinet, a projection of the first sub-control portion 101 on the first side wall is located above a projection of the second shelf on the first side wall.

In some embodiments, a projection of the second sub-control portion 103 on the first side wall is located above a projection of the second shelf on the cabinet door.

In some embodiments, in the width direction of the combiner cabinet, a projection of the first sub-control portion 101 on the first side wall is located above a projection of the second shelf on the first side wall. Meanwhile, the projection of the second sub-control portion on the first side wall is located above the projection of the second shelf on the cabinet door.

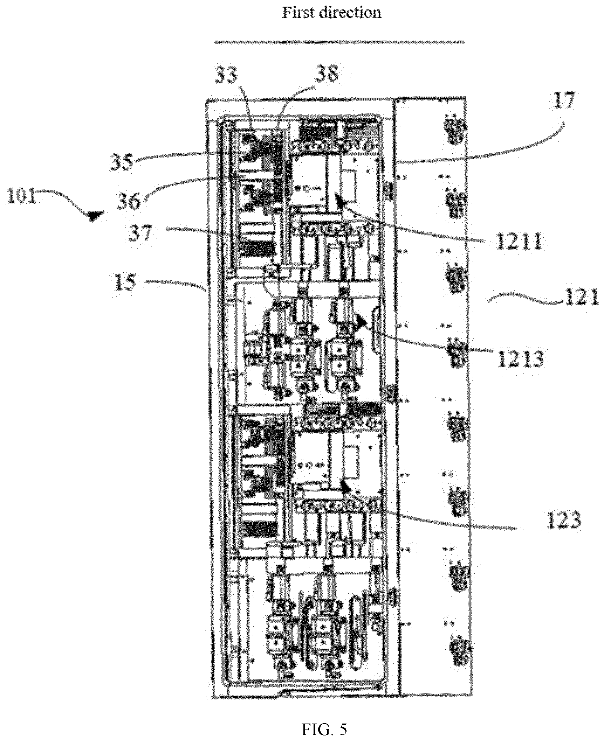

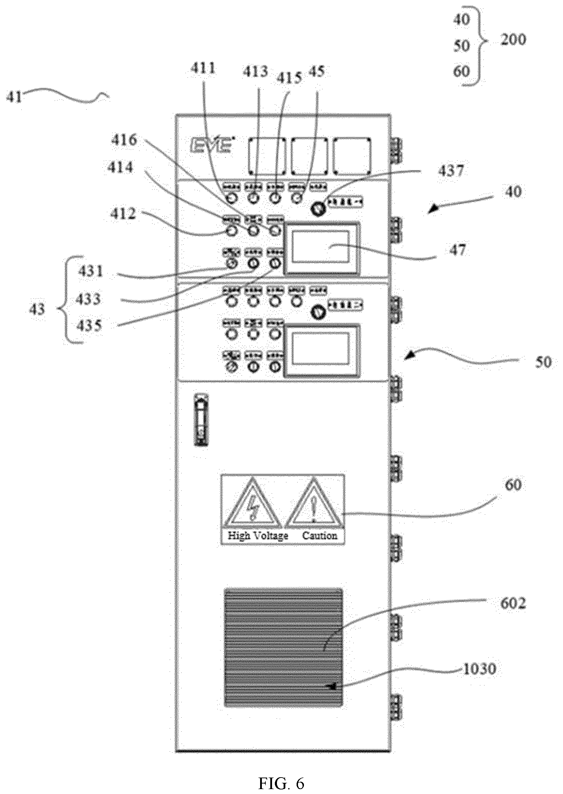

Please refer to FIG. 5 and FIG. 6, the first sub-control portion is configured to control an indicator light module 41 and a switch module 43. The first sub-control portion includes a signal relay 33, an air switch 35, a wiring groove 36, a wiring terminal 37, and an AC/DC power supply 38. The second sub-control portion 103 includes a BMS control part 31. The communication signal terminal is powered to the control portion through the AC/DC power supply in the combiner cabinet.

Specifically, in the first mounting space 1211, a first support plate is mounted on a side, facing the third side wall of the cabinet body, of the second side wall of the cabinet body, and the first sub-control portion is mounted on the first support plate and mounted on the second side wall through the first support plate. A second support plate is mounted on a side, facing the second side wall of the cabinet body, of the third side wall of the cabinet body, and the second sub-control portion is mounted on the second support plate and mounted on the third side wall through the second support plate.

In some embodiments, the BMS control part 31 is mounted on the second support plate, and is configured to manage a battery, and mounted on the third side wall through the second support plate. The communication signal terminal of the external high-voltage box enters the combiner cabinet through a wire entrance and is connected to the BMS control part 31. There are also multiple BMS battery management systems, and each BMS battery management system is configured to control one battery system. In some embodiments, there are two battery systems and two BMS battery management systems, so that the two battery systems are managed separately.

Specifically, a guide rail is mounted on the first support plate. The wiring terminal 37, the signal relay 33, and the air switch 35 are all mounted on the guide rail in a snap-fit manner. The AC/DC power supply 38 is mounted on the first support plate.

In some embodiments, an indicator light and a switch are mounted on the cabinet door and located on an out side, facing away from the mounting chamber, of the cabinet door. The indicator light and the switch are connected to the wiring terminal through a wire harness, and the wiring terminal is connected to the signal relay and the air switch through the wire harness. The wire harness is gathered at the wiring groove and connected to the BMS control 31, and the BMS control part 31 outputs signals to the driver's console through the wire harness.

In some embodiments, each first electrical element assembly 14 further includes an auxiliary power portion. The auxiliary power portion is mounted on the second shelf 23 and the third shelf 25. The auxiliary power portion 300 includes an auxiliary power positive fuse 301, an auxiliary power negative fuse 303, an auxiliary power positive electrode interface 305, and an auxiliary power negative electrode interface 307. The auxiliary power positive fuse 301 and the auxiliary power positive electrode interface 305 are mounted on the second shelf 23. The auxiliary power negative fuse and the auxiliary power negative electrode interface 307 are mounted on the third shelf 25. The first circuit breaker 741, the auxiliary power positive fuse 301, and the auxiliary power positive electrode interface 305 are electrically connected to each other in sequence. The auxiliary positive electrode is configured to be electrically connected to a positive electrode of an auxiliary power cabinet.

The second circuit breaker 743, the auxiliary power negative fuse 303, and the auxiliary power negative electrode interface 307 are electrically connected to each other in sequence, and the auxiliary power negative electrode is configured to be electrically connected to a negative electrode of the auxiliary power cabinet.

The auxiliary power positive electrode interface 305 and the auxiliary power negative electrode interface 307 are configured to be connected to the auxiliary power cabinet, and are also charge the auxiliary power cabinet. In addition, the auxiliary power positive fuse 301 and the auxiliary power negative fuse 303 are arranged to satisfy the requirement of arranging a separate fuse for each circuit.

Specifically, the positive electrode output terminal of the high-voltage box is connected to the cluster high-voltage positive electrode wiring copper busbar through a wire harness, and connected to the circuit breaker through the cluster high-voltage positive electrode-to-circuit breaker copper busbar. The circuit breaker is connected to the auxiliary power positive fuse 301, the auxiliary power positive fuse 301 is connected to an auxiliary power positive output wire harness through the auxiliary power positive copper busbar, and the auxiliary power positive output wire harness is connected to the auxiliary power positive electrode interface 305.

The negative electrode output terminal of the high-voltage box is connected to the cluster high-voltage negative electrode wiring copper busbar through a wire harness, and connected to the circuit breaker through the cluster high-voltage negative electrode-to-circuit breaker copper busbar. The circuit breaker is connected to an auxiliary power negative fuse 303, and the auxiliary power negative fuse 303 is connected to an auxiliary power negative output wire harness through the auxiliary power negative copper busbar. The auxiliary power negative output wire harness is connected to the auxiliary power negative electrode interface 307.

In some embodiments, each first electrical element assembly 14 further includes an electrical surge protection portion 400. The electrical surge protection portion 400 is mounted on the second shelf 23, and the electrical surge protection portion 400 includes a first electrical surge fuse 401, an electrical surge protector 405, and a second electrical surge fuse 403. The first circuit breaker 741, the first electrical surge fuse, the electrical surge protector, the second electrical surge fuse, and the second circuit breaker 743 are electrically connected to each other in sequence to form an anti-electrical surge protection circuit. The anti-electrical surge protection circuit is arranged and configured to prevent equipment from being damaged by lightning stroke.

Specifically, the first circuit breaker 741 is electrically connected to the circuit breaker-to-output positive copper busbar, and the second circuit breaker 743 is electrically connected to the circuit breaker-to-output negative copper busbar. One terminal of the first electrical surge fuse is connected to the circuit breaker-to-output positive copper busbar through a wire harness, so that the first electrical surge fuse is electrically connected to the first circuit breaker 741. Another terminal of the first electrical surge fuse is connected to the electrical surge protector. One terminal of the electrical surge protector is connected in series to the second electrical surge fuse through a wire harness. The second electrical surge fuse is connected to the circuit breaker-to-output negative copper busbar through a wire harness, so that the second electrical surge fuse is electrically connected to the second circuit breaker 743. The circuit breaker-to-output copper busbar is mounted on a side, facing the cabinet door, of the second shelf 23. The circuit breaker-to-output negative copper busbar is mounted on a side, facing the cabinet door, of the third shelf 25.

In some embodiments, guide rails and insulating posts are mounted on the second shelf 23, and the guide rails are configured to fix the electrical surge protector to improve mounting efficiency and mounting stability. The first electrical surge fuse and the second electrical surge fuse are fixed on the insulating posts of a support plate.

Please refer to FIG. 8, in some embodiments, a manhole is formed in the shelf. The manhole hole is configured as a waist-type manhole 201. In case that the wire harness is loose, the wire harness is directly reinforced without disassembling an outer shelf close to the cabinet door; so as to facilitate reinforcement and maintenance.

In some embodiments, the shelf is covered with a PC film to improve insulating performance. Specifically, a side, facing the cabinet door, of the shelf is covered with the PC film.

In some embodiments, an insulating plate 603 is mounted on a side away from the cabinet door, and is configured to increase electrical clearances between copper busbars and improve insulating performance. The insulating plate 603 is configured as an acrylic insulating plate.

In some embodiments, each electrical element assembly 14 further includes an adjusting and indicating portion 200. The adjusting and indicating portion is mounted on a side, away from the mounting chamber, of the cabinet door and is configured to adjust and indicate working conditions of a battery pack.

The adjusting and indicating portion 200 includes a first operation module 40, a second operation module 50, and a warning module 60. The first operation module 40, the second operation module 50, and the warning module 60 are arranged from top to bottom in the height direction of the cabinet body.

The first operation module is configured to display and control the working conditions of the first battery pack, and the second operation module is configured to display and control the working conditions of the second battery pack.

In the embodiments of the present invention, since the control portion for the first battery pack and the control portion for the second battery pack are arranged separately, when a fault occurs, it is intuitively identified from which battery pack the fault comes, and input and output of the battery pack are cut off in time to avoid significant losses. Therefore, the states of the high-voltage box of two battery packs are monitored, and the overall communication of two battery systems is integrated and output to the driver's console.

The first operation module is explained as follows. The first operation module 40 includes an indicator light module 41, a switch module 43, a buzzer 45, and a display module 47. The states of the first battery pack are fed back and controlled in time through the first operation module 40. The indicator light module 41 and the switch module 43 are both electrically connected to the control portion.

The display modules are arranged on one side and another side, connected to the cabinet body, of the cabinet door, and the indicator light module is arranged on a side of the display module and is arranged at intervals with the display module.

The indicator light module 41 includes an operation indicator light 411, a fault indicator light 413, a closing indicator light 415, an over-high temperature indicator light 412, a 24V voltage indicator light 414, and a low State of Charge (SOC) indicator light 416. The indicator light module is arranged in two parallel rows, with a first row including the operation indicator light, the fault indicator light, and the closing indicator light, and a second row including the over-high temperature indicator light, the 24V voltage indicator light, and the low SOC indicator light. The indicator light module is arranged in two parallel rows, so that the structure between the first row of the indicator light module and the second row of the indicator light module is compact, which makes it convenient for operators to operate.

The switch module 43 includes a remote/local control switch 431, a start/stop control switch 433, and a silencer control switch 435. The remote/local control switch 431, the start/stop control switch 433, and the silencer control switch 435 are arranged in one row, and are configured to be arranged in parallel with the indicator light module. Therefore, the indicator light module 41 and the switch module 43 are arranged in parallel. From top to bottom, the first row of the indicator light module 41, and the second row of the indicator light module 41, and the switch module 43 are arranged in sequence. Thus, the structure between the switch module and the indicator light module is compact. Position of the first row of the indicator light module is higher than that of the display module 47. A mounting space is arranged between a side, facing the display module, of the first row of the indicator light module and the display module. A buzzer and an emergency stop switch 437 are mounted in the mounting space, which is convenient for operators to operate and is not easily touched by mistake. The buzzer is arranged to be close to the first row of the indicator light module, and the buzzer is located above the display module. The emergency stop switch is located between the buzzer and the display module 47.

The display module 47 is mounted on the cabinet door and configured to display relevant parameters and working conditions. The display modules 47 for the first battery pack and the second battery pack are arranged separately. The display modules 47 for the two battery packs are independent of each other and do not interfere with each other. Battery states of the two battery systems are monitored separately through two display modules 47 on the cabinet door. In some embodiments, a touch screen is used as each of the two display modules 47.

For the structure and efficiency of the second operation module, reference is made to the first operation module. The second operation module is configured to display and control the working conditions of the second battery pack. The first operation module is opened separately to expose its internal structure, and the second operation module is opened separately to expose its internal structure. Meanwhile, the cabinet door is opened as a whole. Once a cabinet lock is unlocked, the cabinet door is opened as a whole from a handle.

The warning module 60 includes identification parts and a cabinet lock. A ventilation part is arranged close to the bottom of the cabinet door, and identification parts are arranged among the ventilation part, the cabinet lock, and the second operation module. The cabinet lock is configured to lock the cabinet door to the cabinet body, and the identification parts are configured as high-voltage warning identifications.

In the embodiments of the present invention, low-voltage indicator lights and control switches for the first battery pack and the second battery pack are arranged separately. The low-voltage indicator light and control switch for each battery pack are independent of the low-voltage indicator light and control switch for another battery pack and do not interfere with each other, so as to control the charging and discharging of the two battery packs separately.

In order to improve heat dissipation efficiency, in the embodiments of the present invention, the combiner cabinet is ventilated for heat dissipation. In some embodiments, an air outlet 1010 is formed at a top of the cabinet body 10, and an air inlet 1030 is formed in the cabinet door. The air inlet and air outlet are both in communication with the mounting chamber 12. An air outlet assembly is configured to discharge the air in the mounting chamber 12 out of the air outlet 1010. The electrical element assembly 14 is mounted in the mounting chamber 12 and configured to combine current of multiple external high-voltage boxes. At least a part of the electrical element assembly 14 is located in an air path between the air inlet and the air outlet. In these embodiments, air enters the cabinet body through the air inlet, the electrical element assembly 14 produces heat during operation. The heated air rises, and passes through the electrical element assembly 14, which fully drives the hot air produced by the electrical element assembly 14 during operation to be discharged upward, so as to avoid the failure of the electrical element assembly 14 caused by accumulation of high temperature. The air inlet 1030 is formed in a position, close to the bottom wall 19, of the cabinet door.

In the embodiments of the present invention, air is charged from the bottom and is discharged from the top, which is beneficial to discharge a large amount of hot air and improve heat dissipation efficiency. The air takes away the heat produced by the electrical element assembly 14 and is discharged from the top of the cabinet body. Thus, the air is discharged from the top, which is beneficial to discharge a large amount of hot air and improve heat dissipation efficiency.

In some embodiments, the combiner cabinet further includes an air outlet assembly. The air outlet assembly is mounted in the mounting chamber 12 and is arranged close to the top of the cabinet body. The air outlet assembly is configured to discharge the air in the cabinet body 10 out of the air outlet 1010. The air outlet assembly and the air outlet 1010 are arranged at the top to improve heat dissipation efficiency.

In some embodiments, the air outlet assembly include a fan, a first filter screen 601, and a second filter screen 602. The fan is configured to allow air to enter the cabinet body, dissipate heat from the internal elements of the cabinet body, and discharge the air in the mounting chamber from the air outlet, that is, discharge the air to the outside. The first filter screen 601 is mounted on the cabinet body 10 and is configured to cover the air outlet 1010. An air inlet assembly includes a second filter screen 602. The second filter screen 602 is mounted on the cabinet door and is configured to cover the air inlet. The second filter screen 602 covers the air inlet to prevent external air carrying particles from entering the cabinet body, which has an adverse impact on the electrical element assembly 14. The first filter screen 601 covers the air outlet to prevent external dust from entering the cabinet body through the air outlet. The fan is, for example, a Roots blower, a centrifugal fan, an axial flow fan, or a jaeger blower, but this is not limited in the present invention.

The first filter screen 601 and the second filter screen 602 are both louvered filters. The fan is a louvered fan. The louvered fan is connected to the BMS control part 31 through a wire harness. The turning on and off of the fan is controlled by the program inside the BMS control part 31 to achieve ventilation and heat dissipation inside the combiner cabinet.

For the air inlet, a louver filter group of a size of 323 mm * 323 mm is applied, and for the air outlet, two louver filter groups each of a size of 204 mm * 204 mm with two 24V DC axial flow fans is applied, with a protection level of IP55, and an air flow of 98 m³/h.

In some embodiments, the louver fan is connected to the BMS control 31 through a wire harness, and the turning on and off of the fan is controlled by the program in the BMS control part 31 to realize ventilation and heat dissipation inside the combiner cabinet.

In some embodiments, the electrical element assembly 14 is arranged on a side, facing the air inlet, of the shelf. In the first direction, a projection of the electrical element assembly 14 on the cabinet door is at least partially located above the air inlet, and/or, the projection of the electrical element assembly 14 on the cabinet door is at least partially located inside the air inlet.

Therefore, the air entering from the air inlet passes through the electrical element assembly 14 on the shelf, so that heat dissipation is improved.

In some embodiments, through holes are formed in multiple shelves, and the through holes penetrate through the multiple shelves along the first direction. In these embodiments, the through holes are formed in the shelves, and the through holes penetrate through the shelves along the first direction. The through holes are configured for mounting the electrical element assembly 14 and are configured for maintenance. Once external air enters between the third shelf 25 and the cabinet door through the air inlet, the air enters between the second shelf 23 and the third shelf 25 through the through holes, and enters between the first shelf 21 and the second shelf 23 through the through holes, which is helpful for heat dissipation.

In embodiments of the present invention, once the external air enters the cabinet body, there are at least two paths for the air. One path for the air is to enter between the first shelf 21 and the second shelf 23, taking away the heat of a part of the first electrical element assembly 14 mounted on the first shelf 21. Another path for the air is to enter between the second shelf 23 and the cabinet door, taking away the heat of a part of the first electrical element assembly 14 mounted on the second shelf 23, and the air is discharged from the air outlet arranged on a top wall. Thus, the heat of the first electrical element assembly 14 is simultaneously dissipated through two paths of air, and the heat dissipation efficiency is high.

In some embodiments, in the first direction, a projection of the first shelf 21 on the cabinet door is at least partially located above a projection of the second shelf 23 on the cabinet door. That is, at least a part of the first shelf 21 is directly opposite to the cabinet door to form a chamber, and the chamber is located above the second shelf 23 and the third shelf 25. In other words, the second shelf and the third shelf 25 are not arranged between at least a part of the first shelf 21 and the cabinet door. Thus, the air entering between the first shelf 21 and the second shelf, as well as the air entering between the second shelf and the cabinet door are gathered in the chamber formed by the first shelf 21 and the cabinet door directly opposite to each other, so that the air is fully discharged from the air outlet, which is conducive to heat dissipation.

The air outlet 1010 is located on a top wall 18, and in the height direction of the combiner cabinet, a projection of the second shelf 23 on the top wall 18 is at least partially located within the air outlet 1010, which is convenient for the air to blow out from the air outlet.

In some embodiments, the cabinet body further includes an insulating plate 603, and the insulating plate 603 is arranged on a side, facing away from the cabinet door, of at least one shelf. Thus, electrical clearances between the electrical element assemblies 14 is increased, the heat dissipation and insulation performance of, for example, the copper busbars, are improved.

In a second aspect, the embodiments of the present invention further provide an energy storage system, and the energy storage system includes a combiner cabinet in any one of the embodiments as described above.

## Claims

1. A combiner cabinet, **characterized in that** the combiner cabinet comprises:
a cabinet body (10), a cabinet door (11), and at least one electrical element assembly (14), wherein a mounting chamber (12) is formed in the cabinet body (10), the cabinet door (11) is connected to the cabinet body (10) to cover or expose the mounting chamber (12), the cabinet body (10) comprises a first side wall (13) arranged opposite to the cabinet door (11), the cabinet door (11) and the first side wall (13) are arranged along a first direction; the at least one electrical element assembly (14) is arranged in the mounting chamber (12), the at least one electrical element assembly (14) comprises a positive electrode portion (70) and a negative electrode portion (80) arranged at intervals, the positive electrode portion (70) is configured to be electrically connected to a positive electrode output terminal of an external high-voltage box and electrically connected to a positive electrode of a battery pack, the negative electrode portion (80) is configured to be electrically connected to a negative electrode output terminal of the external high-voltage box and electrically connected to a negative electrode of the battery pack, and the positive electrode portion (70) and the negative electrode portion (80) are arranged in the first direction.

2. The combiner cabinet of claim 1, wherein the positive electrode portion (70) comprises a positive fuse (71), a positive high-voltage relay (72), and a positive electrode interface (73); the positive fuse (71), the positive high-voltage relay (72), and the positive electrode interface (73) are electrically connected to each other in sequence, the positive fuse (71) is configured to be electrically connected to the positive electrode output terminal of the external high-voltage box, and the positive electrode interface (73) is configured to be electrically connected to the positive electrode of the battery pack.

3. The combiner cabinet of claim 2, wherein the at least one electrical element assembly (14) further comprises a first circuit breaker (741), the first circuit breaker (741) is mounted in the mounting chamber (12), the first circuit breaker (741) is electrically connected to the positive electrode portion (70), the first circuit breaker and the positive electrode portion (70) are arranged in the first direction, and the first circuit breaker (741) is closer to the first side wall (13) than the positive electrode portion (70) and the negative electrode portion (80).

4. The combiner cabinet of claim 3, wherein the negative electrode portion (80) comprises a negative fuse (81), a negative high-voltage relay (82), and a negative electrode interface (83); the negative fuse (81), the negative high-voltage relay (82), and the negative electrode interface (83) are electrically connected to each other in sequence, the negative fuse (81) is configured to be electrically connected to the negative electrode output terminal of the external high-voltage box, and the negative electrode interface (83) is configured to be electrically connected to the negative electrode of the battery pack.

5. The combiner cabinet of claim 3 or 4, wherein the at least one electrical element assembly (14) further comprises a second circuit breaker (743), the second circuit breaker (743) is mounted in the mounting chamber (12), the second circuit breaker (743) is electrically connected to the negative electrode portion (80), and the second circuit breaker and the negative electrode portion (80) are arranged in the first direction.

6. The combiner cabinet of claim 5, wherein the combiner cabinet further comprises a plurality of shelves (20), the plurality of the shelves (20) comprises a first shelf (21), a second shelf (23), and a third shelf (25) arranged in the first direction in sequence, the first shelf (21) is closer to the first side wall (13) than the second shelf (23) and the third shelf (25), the first circuit breaker (741) and the second circuit breaker (743) are mounted on a side, close to the cabinet door (11), of the first shelf (21), the positive electrode portion (70) is mounted on a side, close to the cabinet door (11), of the second shelf (23), and the negative electrode portion (80) is mounted on a side, close to the cabinet door (11), of the third shelf (25).

7. The combiner cabinet of claim 6, wherein the combiner cabinet further comprises a pre-charging resistance (91) mounted on a side, facing the second shelf (23), of the first shelf (21), and the pre-charging resistance (91) is configured to protect the positive fuse (71), the negative fuse (81), the positive high-voltage relay (72), and the negative high-voltage relay (82).

8. The combiner cabinet of claim 6 or claim 7, wherein the at least one electrical element assembly (14) further comprises a first copper busbar (701) and a second copper busbar (801), the positive electrode portion (70) is electrically connected to the positive electrode output terminal of the external high-voltage box through the first copper busbar (701), and the negative electrode portion (80) is electrically connected to the negative electrode output terminal of the external high-voltage box through the second copper busbar (801).

9. The combiner cabinet of claim 8, wherein the first copper busbar (701) is mounted on the first shelf (21), the second copper busbar (801) is mounted on the first shelf (21), and the second copper busbar (801) and the first copper busbar (701) are arranged at intervals.

10. The combiner cabinet of any one of claims 1 to 4, wherein the at least one electrical element assembly (14) further comprises a control portion (100), the control portion (100) is mounted in the mounting chamber (12), the control portion (100) is configured to be electrically connected to the positive electrode portion (70), the negative electrode portion (80) and the battery pack, the control portion (100) is configured to be electrically connected to a communication signal terminal of the external high-voltage box to detect states of the external high-voltage box and the battery pack.

11. The combiner cabinet of claim 10, wherein the control portion (100) and the positive electrode portion (70) are arranged in a length direction of the combiner cabinet, and the positive electrode portion (70) and the negative electrode portion (80) are arranged in the first direction.

12. The combiner cabinet of claim 10, wherein the control portion (100) comprises a first sub-control portion (101) and a second sub-control portion (103), and the first sub-control portion (101), the positive electrode portion (70), and the second sub-control portion (103) are arranged in sequence in a length direction of the combiner cabinet.

13. The combiner cabinet of claim 12, wherein the second sub-control portion (103) comprises a Battery Management System (BMS) control part 31, and the BMS control part 31 is configured to be electrically connected to the communication signal terminal of the external high-voltage box.

14. The combiner cabinet of claim 13, wherein the at least one electrical element assembly (14) further comprises an adjusting and indicating portion (200), the adjusting and indicating portion (200) is mounted on a side, away from the mounting chamber, of the cabinet door and is configured to adjust and indicate working conditions of the battery pack.

15. An energy storage system, **characterized in that** the energy storage system comprises the combiner cabinet of any one of claims 1 to 14.
